# EUROPEAN PATENT SPECIFICATION

(11) **EP 2 827 376 B1**
(45) Date of publication and mention of the grant of the patent: **03.05.2017**
(21) Application number: 12871004.3
(22) Date of filing: 16.03.2012
(51) Int. Cl.: H01L 31/0224, H01L 31/048

(54) **SOLAR CELL MODULE**
SOLARZELLENMODUL
MODULE DE CELLULE SOLAIRE

(43) Date of publication of application: 21.01.2015
(73) Proprietor: Panasonic Intellectual Property Management Co., Ltd., Osaka-shi, Osaka 540-6207 (JP)
(72) Inventor: NISHIWAKI, Takeshi, Moriguchi-shi Osaka 570-8677 (JP)
(74) Representative: Glawe, Delfs, Moll
(86) International application number: PCT/JP2012/056861
(87) International publication number: WO 2013/136511

(56) References cited:
- EP-A1- 1 783 159
- WO-A1-2011/026852
- JP-A- H02 143 469
- JP-A- 2007 329 240
- JP-A- 2008 108 948
- JP-A- 2012 009 706
- JP-A- 2012 044 024

## Description

### TECHNICAL FIELD

The invention relates to a solar cell module.

### BACKGROUND ART

There have been known solar cell modules each including multiple solar cells disposed in a filler layer containing an ethylene-vinyl acetate copolymer (for example, Patent Document 1).

### PRIOR ART DOCUMENT

### PATENT DOCUMENT

Patent Document 1: Japanese Patent Publication Application No. 2011-155175
Patent Document 2: EP1783159, which discloses a solar cell module (see fig. 1) comprising a first protection member (11), a second protection member (12), a sealing material (13A, 13B) and an array of solar cells (14) therein. The sealing resin comprises a resin film and additionally a chemically basic compound in order to neutralize acetic acid occurring within the module (see par. 46).

### SUMMARY OF THE INVENTION

### PROBLEM TO BE SOLVED BY THE INVENTION

There is a demand for improvement of weather resistance of solar cell modules.

A main object of the invention is to provide a solar cell module with improved weather resistance.

### MEANS FOR SOLVING THE PROBLEM

A solar cell module according to the invention includes a solar cell and a sealing material. The solar cell includes a photoelectric conversion body, a transparent conductive oxide layer, and an electrode. The transparent conductive oxide layer is disposed on a first main surface of the photoelectric conversion body. The electrode is disposed on the transparent conductive oxide layer. The sealing material seals the solar cell. A portion of the sealing material located on the electrode contains an ethylene-vinyl acetate copolymer. The electrode contains a basic compound.

### EFFECT OF THE INVENTION

The invention can provide a solar cell module with improved weather resistance.

### BRIEF DESCRIPTION OF THE DRAWINGS

[Fig. 1] Fig. 1 is a schematic cross-sectional view of a solar cell module according to an embodiment of the invention.
[Fig. 2] Fig. 2 is a schematic back side view of a solar cell according to the embodiment of the invention.
[Fig. 3] Fig. 3 is a schematic cross-sectional view of the solar cell according to the embodiment of the invention.

### MODES FOR CARRYING OUT THE INVENTION

Hereinafter, examples of preferred embodiments in which the invention is practiced are described. Note that, the following embodiments are mere examples. The invention is not limited the following embodiments.

Moreover, in the drawings referred in the embodiments and the like, the members having substantially same functions are referred as the same reference numerals. Moreover, the drawings referred in the embodiments and the like are schematically illustrated, and the ratios of sizes or the like of objects rendered in the drawings may differ from the ratios of sizes or the like of actual objects. The ratios of sizes or the like of objects may also differ among the drawings. The ratios of sizes or the like of specific objects should be determined in consideration of the following description.

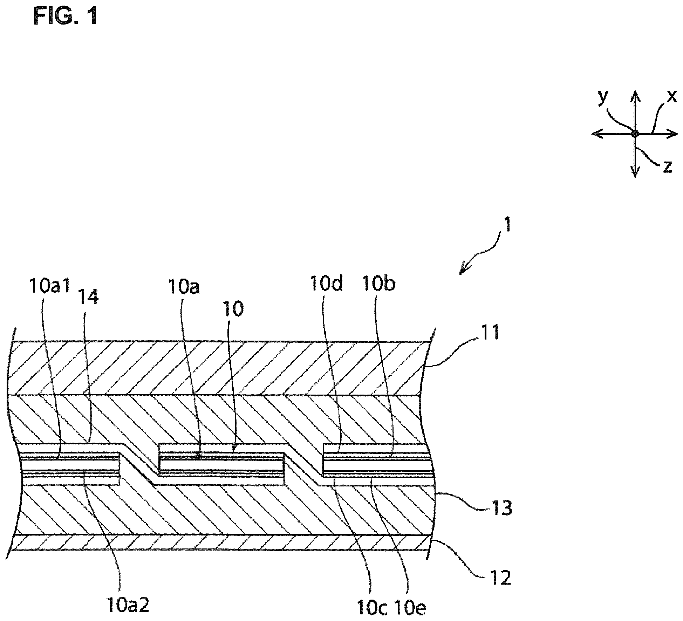

As illustrated in Fig. 1, solar cell module 1 includes solar cells 10. Specifically, solar cell module 1 includes multiple solar cells 10 electrically connected to each other by wiring materials 14.

Solar cell 10 includes photoelectric conversion body 10a. Photoelectric conversion body 10a generates carriers when receiving light. Photoelectric conversion body 10a may include, for example, a substrate made of a semiconductor material, a first semiconductor layer that is disposed on the substrate made of the semiconductor material and has one conductivity type, and a second semiconductor layer that is disposed on the substrate made of the semiconductor material, and has the other conductivity type. Photoelectric conversion body 10a may include, for example, a substrate made of a semiconductor material and including a p-type dopant diffusion region and an n-type dopant diffusion region that are exposed on the surface of the substrate.

Transparent or translucent conductive oxide layer 10b is disposed on first main surface 10a1 of photoelectric conversion body 10a. Transparent conductive oxide layer 10b is disposed on substantially entire first main surface 10a1 excluding peripheral edges thereof. Transparent or translucent conductive oxide layer 10c is disposed on second main surface 10a2 of photoelectric conversion body 10a. Transparent conductive oxide layer 10c is disposed substantially entire second main surface 10a2 excluding peripheral edges thereof.

Transparent conductive oxide layers 10b, 10c can be made of, for example, indium tin oxide (ITO), indium zinc oxide (IZO), aluminum zinc oxide (AZO), or the like. The thickness of each of transparent conductive oxide layers 10b, 10c can be set to about 30 nm to 20 nm, for example.

First electrode 10d is disposed on transparent conductive oxide layer 10b. Second electrode 10e is disposed on transparent conductive oxide layer 10c. One of first and second electrodes 10d, 10e is an electrode that collects majority carriers, and the other one is an electrode that collects minority carriers.

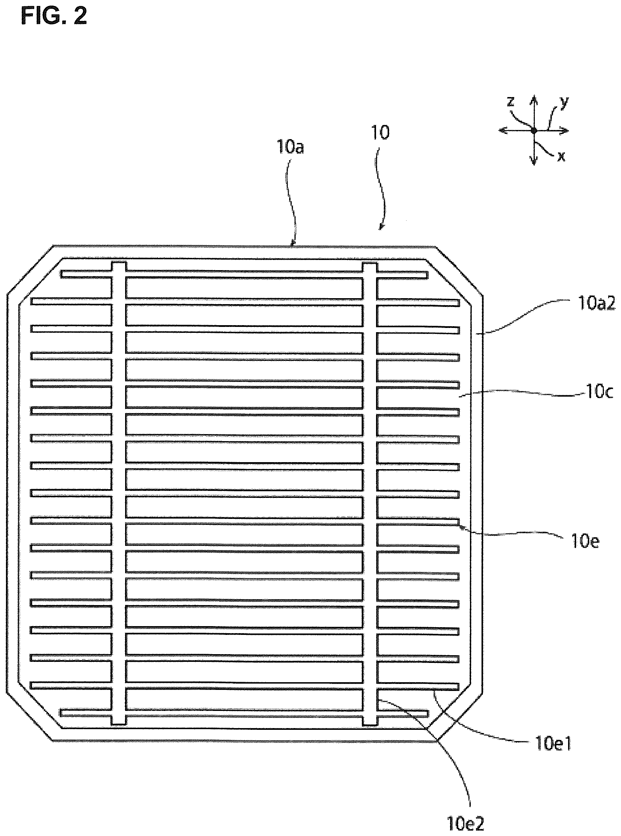

As illustrated in Fig. 2, second electrode 10e includes multiple finger portions 10e1 and bus bar portions 10e2. Finger portions 10e1 are arranged at intervals in X-axis direction. Finger portions 10e1 are electrically connected to bus bar portions 10e2. Second electrode 10e is electrically connected to wiring materials 14 mainly at bus bar portions 10e2. Finger portions 10e1 include parts not covered with wiring materials 14. The parts of finger portions 10e1 not covered with wiring materials 14 are in direct contact with sealing material 13.

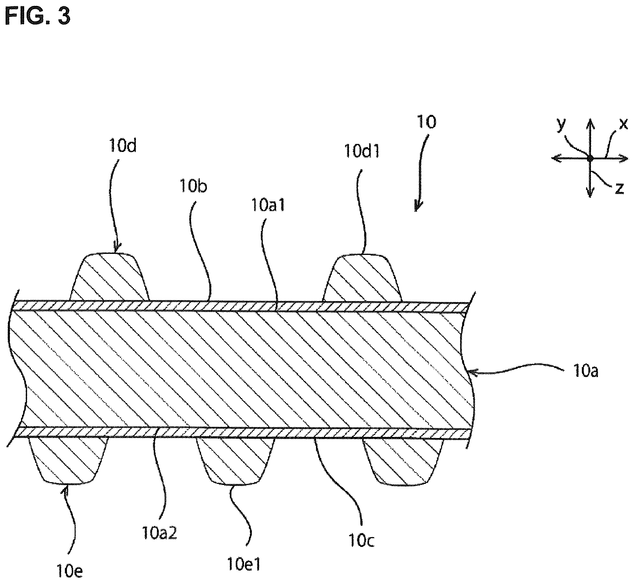

Similarly, first electrode 10d also includes multiple finger portions 10d1 disposed at intervals in X-axis direction (see Fig. 3), and bus bar portions to which those finger portions are electrically connected. First electrode 10d is electrically connected to wiring materials 14 mainly at these bus bar portions. Finger portions 10d1 include parts not covered with wiring materials 14. The parts of finger portions 10d1 not covered with wiring material 14 are in direct contact with sealing material 13. The pitch between finger portions 10e1 in second electrode 10e is narrower than the pitch between finger portions 10d1 in first electrode 10d.

Solar cells 10 are provided inside sealing material 13 disposed between first protection member 11 provided on a light-receiving side and second protection member 12 provided on a back side. First protection member 11 is disposed on sealing material 13 at the light-receiving side of solar cells 10. Second protection member 12 is disposed on sealing material 13 at the back side of solar cells 10. Sealing material 13 seals solar cells 10. First protection member 11 can be made of, for example, a glass or ceramic. Second protection member 12 can be made of, for example, a resin sheet containing a barrier layer such as a metal layer, or a resin sheet not containing a barrier layer such as a metal layer.

A portion in sealing material 13 located on second electrode 10e contains an ethylene-vinyl acetate copolymer (EVA). More specifically, a portion in sealing material 13 located between solar cells 10 and second protection member 12 contains the ethylene-vinyl acetate copolymer. A portion in sealing material 13 located on first electrode 10d may contain or may not contain the ethylene-vinyl acetate copolymer. A portion in sealing material 13 located between solar cells 10 and first protection member 11 may contain or may not contain the ethylene-vinyl acetate copolymer. In other words, entire sealing material 13 may contain an ethylene-vinyl acetate copolymer (EVA), or only the portion in sealing material 13 located on second electrode 10e may contain the ethylene-vinyl acetate copolymer. When the portion in sealing material 13 located on first electrode 10d contains no ethylene-vinyl acetate copolymer, the portion can be made of, for example, polyolefin such as polyethylene. Herein, an explanation is given for an example where entire sealing material 13 contains the ethylene-vinyl acetate copolymer.

Each of first and second electrodes 10d, 10e contains a conductive material and a basic compound. The basic compound reacts with acetic acid to neutralize the acetic acid. Therefore, even when moisture enters sealing material 13 containing the ethylene-vinyl acetate copolymer to generate acetic acid in sealing material 13, the acetic acid is less likely to reach transparent conductive oxide layers 10b, 10c through electrodes 10d, 10e. This inhibits the acetic acid from dissolving transparent conductive oxide layers 10b, 10c. Accordingly, increase in electrical resistivity of transparent conductive oxide layers 10b, 10c is suppressed. As a result, solar cell module 1 with improved moisture resistance can be obtained.

When second protection member 12 is made of a resin sheet without including a barrier layer, the moisture is more likely to enter sealing material 13, and accordingly acetic acid is more likely to be generated. For this reason, it is more effective that first and second electrodes 10d, 10e be formed to contain the basic compounds. When first protection member 11 is made of a glass or ceramic and second protection member 12 is made of a resin sheet, acetic acid is more likely to be generated in the portion in sealing material 13 located between solar cells 10 and second protection member 12. To address this, formation of second electrode 10e containing the basic compound is especially effective.

First and second electrodes 10d, 10e each containing a conductive material and a basic compound can be formed with application of a paste containing the conductive material and a polymeric material containing an amino group or an imino group, for example.

Examples of the conductive material preferably used include metals such as Ag, Cu, and Al. A metal or the like used as a conductive material reacts with acetic acid to form a metal salt or the like of the acetic acid. If metal salts are formed in first and second electrodes 10d, 10e, the conductivity in first and second electrodes 10d, 10e may be deteriorated. To cope with this, first and second electrodes 10d, 10e contain the polymeric material containing the amino group or the imino group to thereby inhibit a reaction between a metal containing in a conductive agent and the acetic acid. This can effectively inhibit the conductivity of first and second electrodes 10d, 10e from being deteriorated.

Specific examples of the polymeric material containing an amino group or an imino group preferably used include polyethylene, polyvinylamine, and polyallylamine. Only one type or two or more types of polymeric materials each containing an amino group or an imino group may be used.

In order to more effectively neutralize the acetic acid, each of first and second electrodes 10d, 10e preferably contains 50 ppm or more of a polymeric material containing an amino group or an imino group. In order to inhibit the conductivity of first and second electrodes 10d, 10e from being deteriorated, 500 ppm or less of a polymeric material containing an amino group or an imino group is preferably contained in each of first and second electrodes 10d, 10e.

The above description is provided for the example in which the back side portion of a sealing material contains an ethylene-vinyl acetate copolymer. However, when a back side portion of the sealing material contains no ethylene-vinyl acetate copolymer and a light-receiving side portion thereof contains an ethylene-vinyl acetate copolymer, it is preferable that first electrode 10d be made of a polymeric material containing an amino group or an imino group. Moreover, the solar cell may be a back contact solar cell in which first and second electrodes are provided at the back side thereof.

### EXPLANATION OF THE REFERENCE NUMERALS

- 1: solar cell module
- 10: solar cell
- 10a: photoelectric conversion body
- 10a1: first main surface
- 10a2: second main surface
- 10b, 10c: transparent conductive oxide layer
- 10d: first electrode
- 10e: second electrode
- 10d1, 10e1: finger unit
- 11: first protection member
- 12: second protection member
- 13: sealing material

## Claims

1. A solar cell module comprising:
a solar cell (10) including a photoelectric conversion body (10a), a transparent conductive oxide layer (10c) disposed on a first main surface (10a2) of the photoelectric conversion body, and an electrode (10e) disposed on the transparent conductive oxide layer;
a sealing material (13) sealing the solar cell therein;
a first protection member (11) disposed on the sealing material at a second main surface side of the solar cell; and
a second protection member (12) disposed on the sealing material at a first main surface side of the solar cell, wherein
a portion of the sealing material (13) located on the electrode (10e) contains an ethylene-vinyl acetate copolymer,
**characterized in that** the second protection member (12) is made of a resin sheet with no metal layer, and
the electrode (10e) contains no less than 50 ppm and no more than 500 ppm of a chemically basic compound containing a polymeric material containing an amino group or an imino group.

2. The solar cell module according to claim 1, wherein
the chemically basic compound contains at least one selected from the group consisting of polyethylenimine, polyvinylamine, and polyallylamine.

3. The solar cell module according to claim 1 or 2, wherein the first protection member is made of a glass plate or a ceramic plate.

4. The solar cell module according to any one of claims 1 to 3, further comprising:
another transparent conductive oxide layer (10b) disposed on a second main surface of the photoelectric conversion body (10a); and
another electrode (10d) disposed on the another transparent conductive oxide layer (10b), wherein
a portion of the sealing material (13) located on the another electrode (10b) contains an ethylene-vinyl acetate copolymer, and
the another electrode (10d) contains a chemically basic compound.

## Patentansprüche

1. Solarzellenmodul, das Folgendes umfasst:
eine Solarzelle (10), die einen fotoelektrischen Wandlungskörper (10a), eine transparente leitende Oxidschicht (10 c), die auf einer ersten Hauptoberfläche (10a2) des fotoelektrischen Wandlungskörpers angeordnet ist, und eine Elektrode (10e), die auf der transparenten leitenden Oxidschicht angeordnet ist, einschließt;
ein Versiegelungsmaterial (13), das die Solarzelle darin versiegelt;
ein erstes Schutzelement (11), das auf dem Versiegelungsmaterial an einer zweiten Hauptoberflächenseite der Solarzelle angeordnet ist; und
ein zweites Schutzelement (12), das auf dem Versiegelungsmaterial an einer ersten Hauptoberflächenseite der Solarzelle angeordnet ist, wobei
ein Teil des Versiegelungsmaterials (13), das auf der Elektrode (10e) angeordnet ist, ein Ethylen-Vinylacetat-Copolymer enthält,
**dadurch gekennzeichnet, dass** das zweite Schutzelement (12) aus einem Harzblatt ohne Metallschicht hergestellt ist und die Elektrode (10e) nicht weniger als 50 ppm und nicht mehr als 500 ppm einer chemisch basischen Verbindung enthält, die ein Polymermaterial enthält, das eine Aminogruppe oder eine Iminogruppe enthält.

2. Solarzellenmodul gemäß Anspruch 1, wobei
die chemisch basische Verbindung mindestens eines ausgewählt aus der Gruppe bestehend aus Polyethylenimin, Polyvinylamin und Polyallylamin enthält.

3. Solarzellenmodul gemäß Anspruch 1 oder 2, wobei das erste Schutzelement aus einer Glasplatte oder einer Keramikplatte hergestellt ist.

4. Solarzellenmodul gemäß einem der Ansprüche 1 bis 3, das weiter umfasst:
eine weitere transparente leitende Oxidschicht (10b), die auf einer zweiten Hauptoberfläche des fotoelektrischen Wandlungskörpers (10a) angeordnet ist; und
eine weitere Elektrode (10d), die auf der weiteren transparenten leitenden Oxidschicht (10b) angeordnet ist,
wobei
ein Teil des Versiegelungsmaterials (13), das auf der weiteren Elektrode (10b) angeordnet ist, ein Ethylen-Vinylacetat-Copolymer enthält und
die weitere Elektrode (10d) eine chemisch basische Verbindung enthält.

## Revendications

1. Module de cellule solaire comprenant :
une cellule solaire (10) comprenant un corps de conversion photoélectrique (10a), une couche oxydante conductrice transparente (10c) disposée sur une première surface principale (10a2) du corps de conversion photoélectrique, et une électrode (10e) disposée sur la couche oxydante conductrice transparente ;
un matériau d'étanchéité (13) rendant étanche la cellule solaire dans celui-ci ;
un premier élément de protection (11) disposé sur le matériau d'étanchéité au niveau d'un second côté de surface principale de la cellule solaire ; et
un second élément de protection (12) disposé sur le matériau d'étanchéité au niveau d'un premier côté de surface principale de la cellule solaire, dans lequel
une partie du matériau d'étanchéité (13) situé sur l'électrode (10e) contient un copolymère d'éthylène-acétate de vinyle,
**caractérisé en ce que** le second élément de protection (12) se compose d'une feuille de résine sans couche de métal, et
l'électrode (10e) contient pas moins de 50 ppm et pas plus de 500 ppm d'un composé chimiquement basique contenant un matériau polymère contenant un groupe amino ou un groupe imino.

2. Module de cellule solaire selon la revendication 1, dans lequel le composé chimiquement basique contient au moins un composé choisi dans le groupe constitué par la polyéthylèneimine, la polyvinylamine et la polyallylamine.

3. Module de cellule solaire selon la revendication 1 ou 2, dans lequel le premier élément de protection se compose d'une plaque de verre ou d'une plaque de céramique.

4. Module de cellule solaire selon l'une quelconque des revendications 1 à 3, comprenant en outre :
une autre couche oxydante conductrice transparente (10b) disposée sur une seconde surface principale du corps de conversion photoélectrique (10a) ; et
une autre électrode (10d) disposée sur l'autre couche oxydante conductrice transparente (10b), dans lequel
une partie du matériau d'étanchéité (13) situé sur l'autre électrode (10b) contient un copolymère d'éthylène-acétate de vinyle, et
l'autre électrode (10d) contient un composé chimiquement basique.
